# EUROPEAN PATENT APPLICATION

(11) **EP 4 844 803 A1**
(43) Date of publication of application: **25.11.2026**
(21) Application number: 25178393.2
(22) Date of filing: 23.05.2025
(51) Int. Cl.: H01J 37/20, G01N 1/32

(54) **SAMPLE HOLDER, ALIGNMENT COMPONENTS, SYSTEMS, AND METHOD FOR PREPARING A SAMPLE FOR ION MILLING**

(71) Applicant: Leica Mikrosysteme GmbH, 1170 Wien (AT)
(72) Inventor: PLANK, Heinz, 1170 Wien (AT); ZIMMERMANN, Michael, 1170 Wien (AT); WURZINGER, Paul, 1170 Wien (AT); FEHRER, Dirk-Oliver, 1170 Wien (AT)
(74) Representative: 2SPL Patentanwälte PartG mbB

(57) **Abstract**

Examples relate to a sample holder (1), alignment components for a sample stage for use in ion milling, systems comprising an alignment component, and a method for preparing a sample for ion milling. The sample holder (1) comprises a body (2) for attaching the sample (5) and a first and second alignment surface (4a, 4b) to be pressed against corresponding alignment surfaces of an alignment component or alignment tool.

## Description

### Technical field

Examples relate to a sample holder, alignment components for a sample stage for use in ion milling, systems comprising an alignment component, and a method for preparing a sample for ion milling.

### Background

Ion milling is a physical etching technique used in material science and semiconductor fabrication to remove material from a sample surface with high precision. In this process, ionized gas particles, typically argon, are accelerated toward the sample surface, causing atoms to be ejected through momentum transfer. This technique is particularly valuable for creating precise structures in materials that are difficult to process using chemical etching methods, and it is widely used in the preparation of samples for electron microscopy, device fabrication, and thin film patterning.

One of the most challenging aspects of ion milling is achieving proper alignment between the sample and the mask. The mask serves as a protective barrier that shields specific areas of the sample from the ion beam, allowing for selective material removal. Even slight misalignments, sometimes on the order of micrometers or less, can lead to etching of areas intended to be protected or incomplete etching of targeted regions. This alignment difficulty is compounded when working with samples that have complex geometries or when attempting to create high-aspect-ratio structures, as the margin for error becomes exceedingly small.

There may be a desire to provide an improved concept for aligning a sample with a mask for use in ion milling.

### Summary

This desire is addressed by the subject matter of the independent claims.

Various examples of the present disclosure are based on the finding that it is highly difficult to attach the sample to the sample stage and align the sample with the mask in a manner that achieves the desired alignment between the mask and the sample. In other systems, to perform this alignment, the sample needs to be attached to a sample holder, which is then attached to the sample stage. Then, the position of the sample holder relative to the sample stage can be adjusted to achieve the desired alignment with the mask. In many cases, the user can only verify whether the sample has been attached correctly to the sample holder (i.e., without angular misalignment) when verifying the alignment between the mask and the sample. If the user determines a misalignment at this point, they need to start over and adjust the attachment of the sample to the sample holder (or even use another sample, if the sample is non-removably attached to the sample holder). In the proposed concept, this process is simplified by allowing for any kind of misalignment between the sample and the sample holder. Instead of trying to avoid the misalignment, the geometry of the sample holder features two alignment surfaces that are used to align the sample holder with the mask. These alignment surfaces can be used to compensate for an angular misalignment of the sample relative to the sample holder - when the sample is attached to the sample holder (e.g., glued to the sample holder), the sample can be prepared (e.g. using mechanical milling, polishing, cutting) together with the sample holder, so that a discontinuous surface (plane) is created across the sample and the alignment surfaces. Assuming the preparation has been performed in line with the orientation of the sample, the alignment surfaces of the sample holder are now also aligned with the orientation of the sample. These alignment surfaces can then be pressed against corresponding alignment surfaces of an alignment component or alignment tool to achieve alignment with the mask. This greatly simplifies the process of aligning the sample with the mask.

Some aspects of the present disclosure relate to a sample holder for use in ion milling. The sample holder comprises a body for attaching the sample. The sample holder further comprises a first and second alignment surface to be pressed against corresponding alignment surfaces of an alignment component or alignment tool. These alignment surfaces, which are intended to be adjusted to the orientation of the sample during pre-processing, can be used to accurately align the sample with the mask, simplifying the process of aligning the sample with the mask.

During use, if necessary, the first and second alignment structures may be adjusted (e.g., using a mechanical preparation process) such that they are aligned with the orientation of the sample. For this purpose, material may be removed from corresponding structures of the sample holder. For example, the first and second alignment surfaces may be formed by surfaces of a first and second structure (of the sample holder). Material may be removed from these structures as part of the process of aligning the alignment surfaces with the orientation of the sample.

In the proposed concept, the sample and sample holder may be pre-processed together to achieve this alignment. For this purpose, the body and the first and second structures may be arranged such that, when material is removed from a sample attached to the body of the sample holder during preparation of the sample for ion milling (i.e., mechanical milling, polishing, cutting), material is also removed from the first and second structures, resulting in a discontinuous planar surface across the resulting surface of the sample and the resulting alignment surfaces. This discontinuous planar surface ensures alignment between the sample and the mask.

In general, preparation of the sample and the sample holder is performed by a tool, such as a milling tool, polishing disc, or cutting blade, that is often larger than the sample and sample holder being prepared. Therefore, the respective components (sample and structures forming the alignment surfaces) may be placed such, that they extend from the sample holder in the same direction, so that the tool does not remove material from other portions of the sample holder. In other words, the body and the first and second structure may be arranged such that, when a sample is attached to the sample holder, the sample protrudes over an edge of the body of the sample holder in a pre-defined direction. Moreover, the first and second structure may also extend beyond the edge of the body in the pre-defined direction. This way, the preparation tool can remove material from the sample and structures without removing material from the body holding the sample.

In some examples, the body of the sample holder may be arranged laterally between the first and second structures. This arrangement projects the orientation of the sample after preparation to the alignment surfaces on both sides of the sample, increasing the stability of the alignment when the sample holder is pressed against the alignment surfaces of an alignment component or alignment tool.

In particular, the first and second structures are block-like structures provided to be partially removed during preparation of the sample for ion milling, resulting in a discontinuous planar surface across the resulting surface of the sample and the resulting alignment surfaces. In this context, a block-like structure is a cuboid (a three-dimensional rectangular shape) that has a sufficiently large upper surface area (e.g., at least 2 by 2 millimeters, or at least 3 by 3 millimeters, or at least 3 by four millimeters) designed to allow for alignment with the alignment surfaces of an alignment component or alignment tool.

In some cases, sample holders may be reused, or sample preparation may be repeated for some reason. To allow for such scenarios, the first and second structures may be replaceable by removably mounting them to the body of the sample holder using screws. In other words, the first and second structures may be removably mounted to the body of the sample holder using screws.

In many other systems, the sample may be attached to the sample holder by clamping the sample between two structures, which allows for later adjustment of the orientation of the sample relative to the sample holder. In the present case, in general, the orientation of the sample relative to the sample holder does not need to be adjusted, as the sample holder itself is adjusted to the orientation of the sample. Therefore, a simpler mechanism for attaching the sample to the sample holder may be used. For example, the body of the sample holder may be provided for attachment of the sample to the sample holder via adhesive. Using adhesive is easier for less experienced users, while avoiding drawbacks of compression-based adjustment schemes, such as the danger of damaging the sample due to compression.

As outlined above, the sample holder can be used both during preparation (where the sample holder is also prepared in addition to the sample) and during ion milling. In other words, the sample holder may be provided for holding the sample during preparation of the sample for ion milling and during ion milling.

Some aspects of the present disclosure relate to a first alignment component for a sample stage for use in ion milling. The first alignment component comprises a mask for partially shielding the sample during ion milling or a holder for fastening the mask to the first alignment component. The first alignment component further comprises first and second alignment surfaces for aligning a sample holder (e.g., the above sample holder) holding a sample with the mask. The first and second alignment surfaces have a defined spatial relationship relative to the mask. By pressing the alignment surfaces of the sample holder to the corresponding alignment surfaces of the first alignment component, alignment between the sample and the mask can easily be achieved.

To further simplify the process, the first alignment component may comprise a mechanism that presses the alignment surfaces of the sample holder to the corresponding alignment surfaces of the first alignment component. In other words, the first alignment component may comprise an alignment mechanism configured to mechanically press the alignment surfaces of the sample holder against the first and second alignment surfaces of the alignment component.

This alignment mechanism may be controlled by the user. For example, the alignment mechanism may comprise an adjustment screw for controlling a deflection of the alignment mechanism. This way, the user can turn the screw until sufficiently strong contact is achieved, providing valuable feedback to the user that alignment has been performed.

In addition to a mechanism for pressing the alignment surfaces together, another mechanism may be used to limit movement of the sample holder perpendicular to the pressing movement, i.e., so that the sample holder is steadied towards the mask. For example, the first alignment component may further comprise a retaining mechanism for limiting a movement of the sample holder perpendicular to a direction of movement of the alignment mechanism.

The sample holder can be used with other types of alignment components as well. Some aspects of the present disclosure relate to a second alignment component for a sample stage for use in ion milling. The second alignment component comprises a mask for partially shielding a sample during ion milling or a holder for fastening the mask to the alignment component. The second alignment component comprises a vessel for an adhesive. The vessel is provided to receive a fixture (i.e., a holder for the sample holder) mechanically coupled to the sample. The adhesive is used to maintain alignment between the sample and the mask. The second alignment component comprises at least one alignment surface for aligning at least the mask or holder with a first and second alignment surface of a sample holder (e.g., the above sample holder) holding the sample via an alignment tool. The at least one alignment surface has a defined spatial relationship with the mask. By pressing the alignment surfaces of the sample holder and the alignment surfaces of the second alignment component to the alignment tool, alignment between sample and mask can easily be achieved. In this second alignment component, the sample holder is not pressed against the alignment component, but against the alignment tool (e.g., having a planar surface against which the respective alignment surfaces press). Alignment between sample holder and mask can then be maintained by gluing the sample holder to the alignment component (via the fixture).

Another aspect of the present disclosure relates to a system comprising the second alignment component and the alignment tool. The alignment tool comprises at least one first alignment surface for aligning the alignment tool with the alignment component and at least one second alignment surface for aligning the alignment tool with at least a first and second alignment surface of a sample holder holding the sample. For example, the at least one first alignment surface and the at least one second alignment surface may be part of the same planar surface. The alignment tool is suitable for aligning the sample holder and the mask via the respective alignment surfaces.

An aspect of the present disclosure relates to a system comprising the second alignment component or the above system. For example, the system may further comprise the fixture. The fixture may be provided to be mechanically coupled to the sample holder. The fixture is to be immersed in the adhesive. Using the fixture, the sample holder can be glued in place to maintain alignment between the sample and the mask.

Some aspects of the present disclosure relate to a method for preparing a sample for ion milling. The method comprises attaching the sample to a sample holder. The sample holder comprises a first and second structure. The method comprises mechanically removing material from the sample and the first and second structure, such that a resulting surface of the sample forms a discontinuous planar surface with a first and second surface of the first and second structure after removing the material from the sample and first and second structure. The method comprises inserting the sample holder with the sample into an alignment component (e.g., the first or second alignment component) for a sample stage for ion milling, such that the surfaces of the first and second structure press against at least one alignment surface of the alignment component or of an alignment tool. The surfaces of the first and second structure are used as alignment surfaces for aligning the sample holder and the sample relative to a mask for partially shielding a sample during ion milling. By removing material from the sample and the sample holder, the alignment surfaces of the sample holder have the same orientation. Assuming the preparation has been performed in line with the orientation of the sample, the alignment surfaces of the sample holder are now also aligned with the orientation of the sample. These alignment surfaces can then be pressed against corresponding alignment surfaces of an alignment component or alignment tool to achieve alignment with the mask. This greatly simplifies the process of aligning the sample with the mask.

For example, the sample may be attached to the sample holder using adhesive. Using adhesive is easier for less experienced users and avoids drawbacks of compression-based adjustment schemes, such as the danger of damaging the sample due to compression.

In some examples, an alignment mechanism of the alignment component may be used to press the surfaces of the first and second structure against a first and second alignment surface of the alignment component. This further simplifies the process of aligning the sample with the mask.

In addition to a mechanism for pressing the alignment surfaces together, another mechanism may be used to limit movement of the sample holder perpendicular to the pressing movement, that is, to steady the sample holder towards the mask. For example, the method may comprise fastening the sample holder to the alignment component using a retaining mechanism of the alignment component.

In some other cases, for example, as discussed in connection with the second alignment component, glue may be used to maintain alignment between the sample and the mask. For example, the method may comprise placing a fixture mechanically coupled to the sample (e.g., the fixture) into a vessel of the alignment component, with the vessel comprising an adhesive. The adhesive may be used to maintain alignment between the sample and the mask.

For example, to accelerate the hardening of the glue, or to cause the glue to harden initially, ultraviolet (UV) light may be used. Thus, the method may further comprise emitting ultraviolet light towards the adhesive to harden the adhesive.

### Short description of the Figures

Some examples of apparatuses and/or methods will be described in the following by way of example only, and with reference to the accompanying figures, in which
Figs. 1a to 1c show schematic diagrams of examples of a sample holder;
Figs. 2a to 2c show schematic diagrams of examples of a first alignment component;
Figs. 2d to 2e show schematic diagrams of examples of a sample holder being inserted into a first alignment component;
Fig. 2f shows a schematic diagram of an example of a sample being ion milled using two ion emitters;
Fig. 3a shows a schematic diagram of an example of a sample being attached to a sample holder, with the sample holder being attached to a fixture;
Fig. 3b shows a schematic diagram of a second alignment component;
Fig. 3c shows a schematic diagram of an example of an alignment tool being pressed against the alignment surfaces of the second alignment component and the sample holder while the fixture is submerged in glue;
Fig. 3d shows a schematic diagram of an example of a sample being aligned with a mask; and
Fig. 4 shows a flowchart of an example of a method for preparing a sample for ion milling.

### Detailed Description

Various examples will now be described more fully with reference to the accompanying drawings in which some examples are illustrated. In the figures, the thicknesses of lines, layers and/or regions may be exaggerated for clarity.

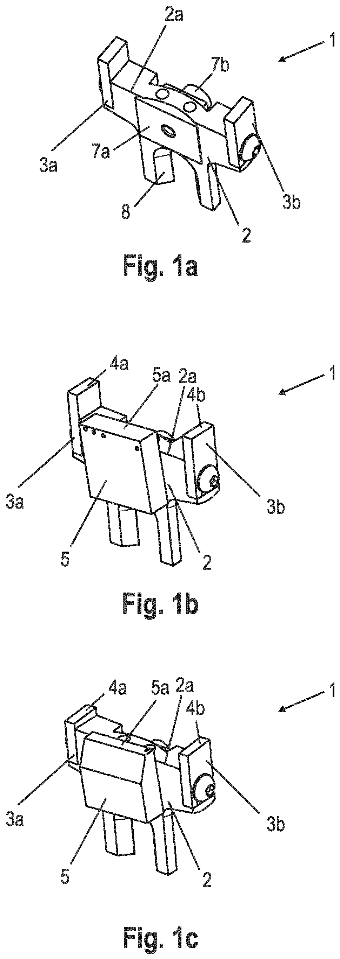

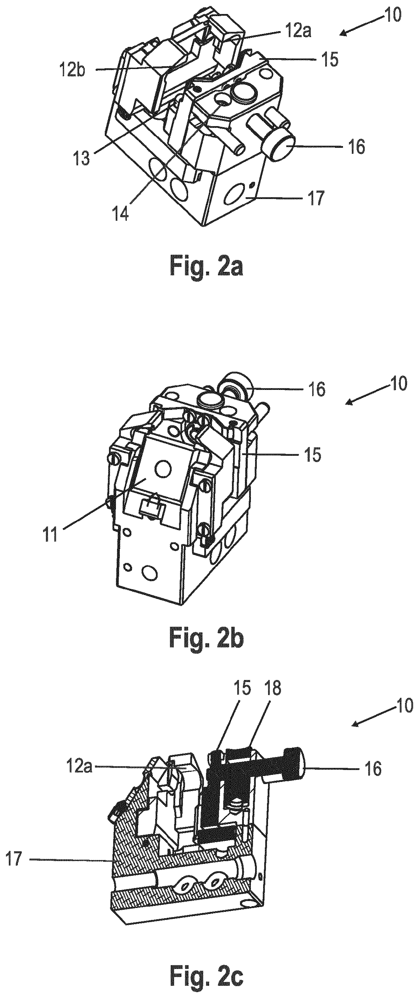

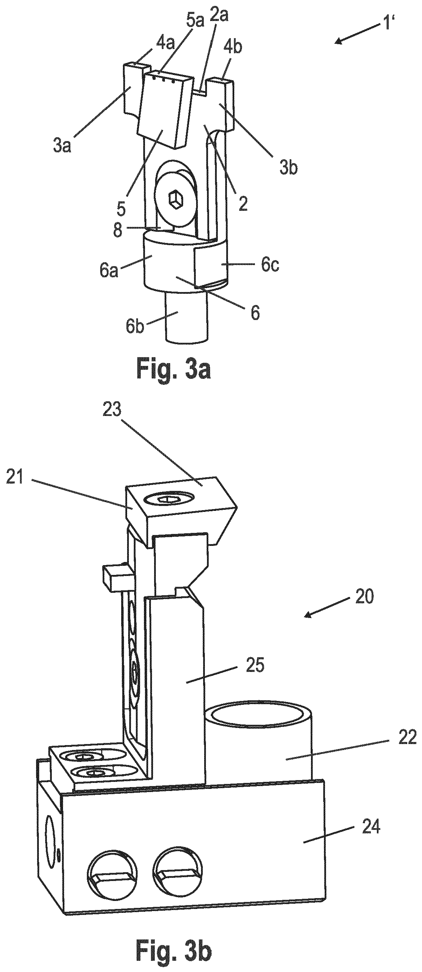

The present disclosure relates to a sample holder, discussed in connection with Figs. 1a to 1c, which can be used in conjunction with at least two types of alignment component, discussed in connection with Figs. 2a to 2f and 3a to 3d, respectively. In this context, a sample holder is a type of fixture that holds the sample to be milled in ion milling. The sample is directly attached to the sample holder, e.g., using adhesive or using a clamping mechanism. In the example shown in connection with Figs. 1a to 3d, adhesive is used to fasten the sample to the sample holder. The respective alignment component, on the other hand, is a tool that assists the user in aligning the sample with the mask (and in particular with the edge of the mask), so that the desired portion of the sample can be removed using ion milling. The alignment component is thus used to align the sample with the edge of the mask. The alignment component is attached to the sample stage.

The proposed concept allows for exact positioning and alignment of the sample (target) relative to the mask for ion milling using an ion mill. In various examples of the proposed concept, the sample is attached to the sample holder using an adhesive. It is then inserted into a preparation device, where it can be milled (mechanically), polished, and/or cut. The sample is automatically oriented and aligned by simultaneously processing (i.e., preparing) the sample and reference surfaces (also called alignment surfaces) of the sample holder. The alignment component is used to align the target (sample holder with sample) relative to the mask, by pressing the reference surface(s) of the sample holder against the mask reference surfaces (also called alignment surfaces) and holding the sample holder in position. This way, the protrusion of the sample relative to the mask is exactly defined. The sample is then placed adjacent to the mask. In case of the second alignment component, the same principle is used, albeit with a different mechanism for fixing the relative position between sample and the mask - in this mechanism, the sample holder is attached to the alignment component using a vacuum-suitable glue, which is hardened using UV radiation.

Figs. 1a to 1c show schematic diagrams of examples of a sample holder 1. The sample holder comprises a body 2 for attaching the sample 5. The body 2 shown in Figs. 1a to 2f comprises a central portion for attaching the sample 5 to the sample holder 1. In the examples of Figs. 1a to 1c, the sample 5 is attached, using adhesive, via an insert 7a having a rounded side that is facing the body 2 of the sample holder 1, allowing for easier attachment of the sample 5. The insert 7a is fastened to the body 2 using a screw 7b. In an alternative implementation, the insert may be omitted, and the sample may be fastened (using adhesive) directly to the body 2 of the sample holder 1. To the sides of the central portion, the body laterally extends to provide a support rest for limiting a rotational movement of block-like structures 3a, 3b to be attached to the body 2 via screws. Towards the bottom, the body 2 of the sample holder further comprises a recess 8 having an open end, thus forming a two-pronged fork. The inner edges of the recess are slanted, corresponding to a slanted shape of the head of a screw being used to fasten the sample holder to another component. The recess 8 allows the sample holder to be fastened to a fixture (see, e.g., Fig. 3a) during ion milling or preparation. The sample holder 1 further comprises the block-like structures (e.g., cuboid structures having a minimal thickness (at the thinnest dimension) of at least 2 millimeters) 3a, 3b, which are removably mounted to the body 2 of the sample holder using screws. The block-like structures are mounted atop the respective support rests of the body 2. Alternatively, as shown in Fig. 3a, the block-like structures 3a, 3b may form an integral piece with the body 2 of the sample holder 1' (of Fig. 3a). The body 2 of the sample holder is arranged laterally between the first and second structures 3a, 3b. As a result, the sample 5, which is attached to the body 2, will also be arranged laterally between the first and second structures 3a, 3b.

Fig. 1a shows the sample holder 1 without the sample 5 being attached. In Fig. 1b, the sample 5 is attached to the body 2 of the sample holder via insert 7a, prior to preparation with a mechanical preparation tool (mechanical milling, polishing, or cutting tool). Laterally, the sample 5 is fastened to the body 2 between the two block-like structures 3a, 3b. The body 2 and the first and second structures 3a, 3b are arranged such that, when the sample 5 is attached to the sample holder, the sample protrudes over an edge 2a of the body 2 of the sample holder in a pre-defined direction (the upward vertical direction in the orientation shown in Figs. 1a to 3d). The first and second structures 3a, 3b extend beyond the edge 2a of the body 2 in the same, pre-defined direction. This is done to allow for joint preparation of the first and second structures 3a, 3b and the sample 5. It is evident that there is a slight angular misalignment between the sample 5 and the sample holder. This angular misalignment can be compensated for during the joint preparation of the sample holder 1 (i.e., of the first and second structures 3a, 3b) and the sample 5. In particular, when material is removed from the sample 5 attached to the body 2 of the sample holder 1 during (mechanical) preparation of the sample for ion milling, material is also removed from the first and second structures 3a, 3b. Thus, the first and second structures 3a, 3b are provided to be partially removed during preparation of the sample for ion milling.

The result of the preparation can be seen in Fig. 1c. Both the structures 3a, 3b and the sample have been prepared (pre-processed) according to a common preparation plane. As a result, a discontinuous planar surface is created across the resulting surface 5a of the sample 5 and the resulting surfaces 4a, 4b of the structures 3a and 3b. This discontinuous planar surface is aligned with the orientation of the resulting surface 5a of the sample 5. As preparation is commonly done in alignment with the orientation of the sample, for example to achieve an exact perpendicular/orthogonal cross-section of the sample, the discontinuous planar surface is commonly also aligned with the (original) orientation of the sample 5.

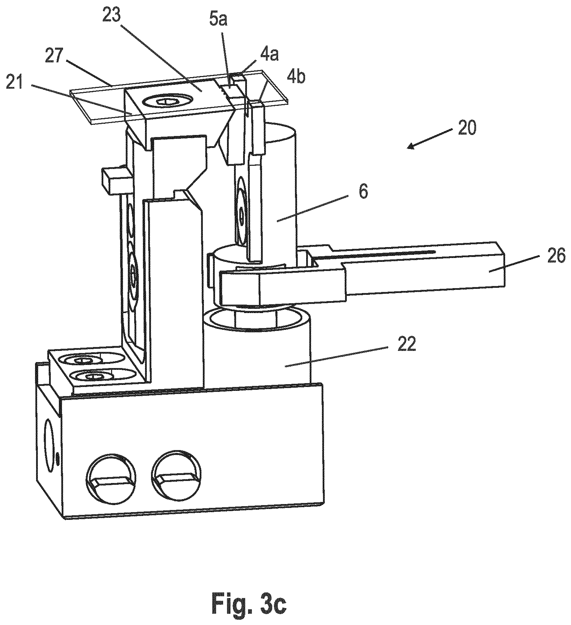

The resulting surfaces 4a, 4b of the first and second structures 3a, 3b can now be used as first and second alignment surfaces 4a, 4b to be pressed against corresponding alignment surfaces 12a, 12b (shown in Figs. 2a to 2f) of an alignment component 10 or alignment tool 27 (shown in Fig. 3c). Thus, the first and second alignment surfaces 4a, 4b are formed by surfaces of the first and second structures 3a, 3b, that is, the surfaces facing in the pre-defined direction. These alignment surfaces 4a, 4b are created from the first and second structures 3a, 3b during the preparation process.

The sample holder shown in Figs. 1a to 1c, which may be used with the alignment components 10, 20 of Figs. 2a to 3d, is designed for use both during mechanical preparation of the sample (so that the alignment surfaces 4a, 4b are aligned with the surface 5a of the sample) and during ion milling (to utilize this alignment for the purpose of aligning the sample 5 with the edge of the mask).

In the following, two types of alignment components are shown for use with the sample holder shown in Figs. 1a to 1c. Examples of the present disclosure further provide systems comprising the respective alignment component (of Figs. 2a to 2f or Figs. 3a to 3d) and the sample holder 1, 1'.

Figs. 2a to 2c show schematic diagrams of examples of a first alignment component 10. The alignment component 10 comprises a base 17, with the remaining components being mounted on the base 17. The base 17 is used to fasten alignment component 10 (including the sample holder 1) to the sample stage. The alignment component 10 is used to align the sample 5 (attached to sample holder 1) with the edge of a mask 11 (shown in Fig. 2b). Thus, the alignment component 10 comprises the mask 11 or at least a holder for fastening the mask 11 to the alignment component 10 (e.g., in a manner that the mask fastened to the alignment component has a defined spatial relationship with the alignment component 10). The mask holder is mounted to an emitter-facing side of the base 17 of the alignment component.

Attached to the same structure the mask holder is attached to, the alignment component 10 further comprises a first and second alignment surface 12a, 12b for aligning the sample holder 1, 1' holding the sample 5 with the mask 11. In the example of Figs. 2a to 2f, the first and second alignment surfaces 12a, 12b are the inner surfaces of a roof-like shape. **The** roof-like shape is split into two portions, with each side comprising one of the alignment surfaces 12a, 12b. Laterally between the two portions of the roof-like shape, the sample is exposed to the beam or beams of the emitter or emitters being used to irradiate the sample.

As the alignment surfaces are formed by the inner surfaces of the roof-like shape, the first and second alignment surfaces 12a, 12b are provided so that corresponding alignment surfaces 4a, 4b of the sample holder 1, 1' can be pressed (from below) onto the first and second alignment surfaces 12a, 12b of the alignment component 10 to provide alignment between the sample 5 and the mask 11. This is achieved by the first and second alignment surfaces 12a, 12b having a defined spatial relationship relative to the mask (as the alignment surfaces are attached to the same structure as the mask holder). In some examples, the first and second alignment surfaces 12a, 12b may have a fixed spatial relationship relative to the mask. In other examples, the position and/or orientation of the mask can be adjusted relative to the first and second alignment surfaces 12a, 12b. In this case, the spatial relationship is defined by the adjustment applied to the position and/or orientation of the mask.

In the alignment component 10 of Figs. 2a to 2f, two mechanisms are included for aligning the sample 5 with the mask 11 and for retaining the sample holder 1 with the sample 5 inside the alignment component. A first mechanism is used to press the alignment surfaces 4a, 4b of the sample holder 1 against the first and second alignment surfaces 12a, 12b of the alignment component. For example, the alignment component may comprise an alignment mechanism 13, 14 configured to mechanically press alignment surfaces of the sample holder against the first and second alignment surfaces 12a, 12b of the alignment component. This alignment mechanism comprises a piston 13 (i.e., an actuator) that presses the sample holder 1 (from below) against the first and second alignment surfaces 12a, 12b, and an adjustment screw 14 for controlling the deflection of the piston 13 of the alignment mechanism. The adjustment screw is thus used to actuate the piston, to press the alignment surfaces of the sample holder, from below, onto the alignment surfaces of the alignment component. For example, the piston may comprise a receptacle for receiving the body 2 of the sample holder 1. For example, the shape of the receptacle may form a counter piece for the shape of the body (and in particular recess 8).

To retain the sample holder inside the alignment component, the sample holder is not only pressed vertically against the first and second alignment surfaces 12a, 12b, but also laterally so that the lateral position of the sample holder 1 is maintained. For this purpose, a retaining mechanism 15, 16 is provided for limiting movement of the sample holder perpendicular to a direction of movement of the alignment mechanism. In other words, if the alignment mechanism 13, 14 exerts pressure in a vertical direction, the retaining mechanism 15, 16 holds the sample holder 1 in a lateral direction. This retaining mechanism comprises a structure 15 that presses against the sample holder 1, and an adjustment screw 16 for controlling the deflection of the structure 15 perpendicular to the direction of movement of the alignment mechanism. The adjustment screw 16 is fixed to the structure 15 and interacts with a screw thread of a structure 18. The structure 18 also hosts the adjustment screw 14 of the alignment mechanism. The structure 15 comprises a shape that is a counter piece to the shape of the sample holder. In a central portion, it comprises a flat portion for applying pressure to the sample holder, and peripheral portions to restrict lateral movement of the sample holder perpendicular to the direction of movement of the alignment mechanism. In the example of Figs. 2a to 2f, the lateral portions are slanted relative to the central portion, to allow for easier insertion of the sample holder.

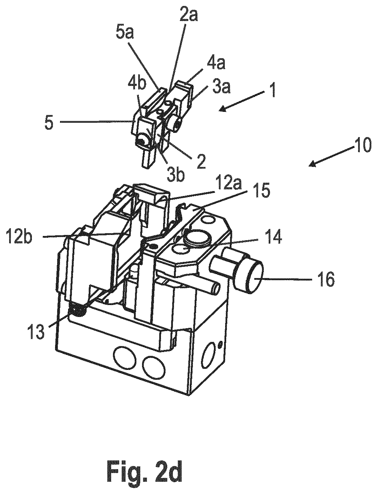

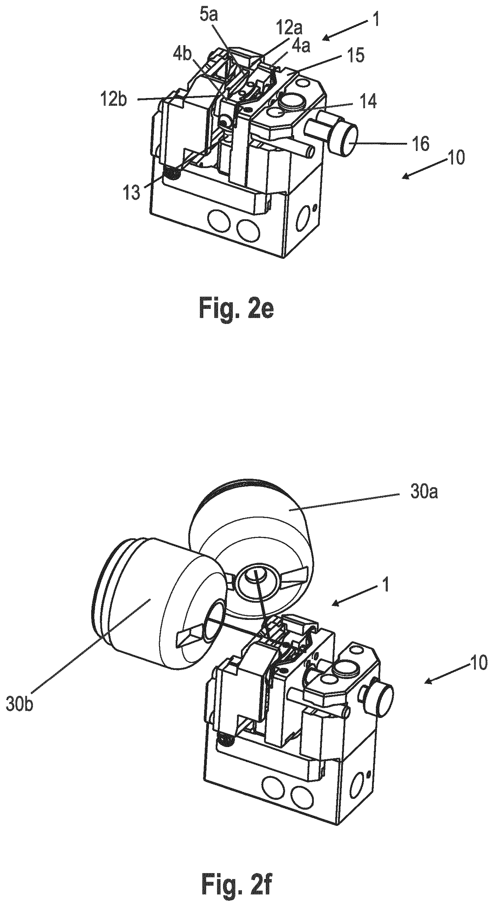

Figs. 2d to 2e show schematic diagrams of examples of the sample holder 1 being inserted into the first alignment component 10. In Fig. 2e, the sample holder has been placed onto the receptacle of the piston 13. Adjustment screw 16 can now be used to push the sample holder 1 towards the mask 11. Subsequently, adjustment screw 14 can be used to press the respective alignment surfaces 4a, 4b, 12a, 12b together.

In Fig. 2f, the alignment component 10 and the sample holder 1 with the sample are shown during ion milling. In the example of Fig. 2f, two ion emitters 30a, 30b are used to emit respective ion beams towards the sample. More generally, a single ion emitter may be used to emit an ion beam towards the sample, or at least two (preferably three) ion emitters may be used to emit respective ion beams towards the sample.

A different type of alignment component is shown in Figs. 3a to 3d. **The** second alignment component 20 discussed in connection with Figs. 3a to 3d is based on fixing the spatial relationship between sample and mask using an adhesive.

When used with the second alignment component 20 the sample holder 1' is attached to a fixture 6. Fig. 3a shows a schematic diagram of an example of a sample 5 being attached (using adhesive) to a sample holder 1', with the sample holder 1' being attached to the fixture 6 (using a screw that traverses the recess 8 of the body 2 of the sample holder).

Prior to attaching the sample holder 1' to the fixture, the sample holder 1' and sample 5 are jointly prepared using a mechanical preparation device. The sample (target) is automatically aligned in the preparation device relative to the mechanical tool being used (mechanical milling tool, polishing disc, cutting/sawing disc etc.). By jointly preparing the sample 5 and the sample holder 1', the structures 3a, 3b of the sample holder 1' are also prepared, creating reference/alignment surfaces 4a, 4b, that are subsequently used for alignment with the mask 21 within the alignment component 20. The sample holder 1' is then fastened to the fixture 6, which is to be partially submerged into glue/adhesive.

This fixture 6 comprises a body portion 6a, a stem 6b to be submerged in glue/adhesive, recesses 6c for alignment of the fixture 6 with a holding tool 26 (gripper, shown in Fig. 3c), and a fastening portion 6d for fastening the sample holder 1' (or 1) to the fixture 6 (e.g., via a screw thread included in the fastening portion 6d). **The** recesses 6c, which are arranged at two lateral sides of the fixture 6, provide vertical and lateral support rests, to prevent the fixture 6 from tilting when being gripped by the gripper. The proposed concept further provides a system comprising the fixture 6 and the alignment component 20, with the fixture 6 being provided to be mechanically coupled to the sample holder 1' and to be immersed in the adhesive.

As outlined above, the stem 6b of the fixture 6 is to be submerged in glue/adhesive. This glue/adhesive is held in a vessel 22 of the second alignment component 20. Fig. 3b shows a schematic diagram of the second alignment component 20. The second alignment 20 also comprises a base 24 that is to be attached to the sample stage, on which the other components are mounted. The base 24 comprises a recess to facilitate mounting of the remaining components to the base 24. On top of the base, an L-shaped holding structure 25 is mounted (using screws). The L-shaped mounting structure comprises a first component (the shorter stem of the L) that is attached to the base 24, a second component (the longer stem of the L) that is oriented perpendicular to the first component. The second component comprises a recess for holding a third component of the L-shaped mounting structure. The third component is screwed to the second component, allowing for adjustment of a vertical height of the L-shaped mounting structure 25.

Similar to the first alignment component 10 of Figs. 2a to 2f, the second alignment component 20 also comprises a (properly justified) mask 21 or a holder for fastening the mask 21 to the alignment component. The L-shaped mounting structure 25 (or at least the third component thereof) forms the holder for fastening the mask 21 to the alignment component. In addition, the second alignment component further comprises the vessel 22 for an adhesive. The vessel is also mounted to the base 24, directly adjacent to the L-shaped mounting structure 25. The vessel 22 is provided to receive the fixture 6 that is mechanically coupled to the sample. The adhesive (that is filled into the vessel) is used to maintain alignment between the sample 5 and the mask 21.

The alignment component further comprises at least one alignment surface 23 for aligning at least the mask 11 or mask holder with a first and second alignment surface 4a, 4b of the sample holder 1' holding the sample 5. This alignment surface 23 has a defined spatial relationship with the mask. Again, the alignment surface 23 may have a fixed spatial relationship relative to the mask 21. In the example provided in Figs. 3b to 3d, this is achieved by using a surface 23 of the mask 21 as an alignment surface. Alternatively, the position and/or orientation of the mask can be adjusted relative to the alignment surface 23. In this case, the spatial relationship is defined by the adjustment applied to the position and/or orientation of the mask. The alignment surface 23 may be provided by a component that is separate from the mask. In contrast to the example of Figs. 2a to 2e, an additional alignment tool 27 (shown in Fig. 3c) is used to perform the alignment. The alignment tool 27 is suitable for aligning the sample holder 1' and the mask 21 via the respective alignment surfaces.

In Fig. 3c, the alignment tool 27 is shown as a planar surface, which is possible as the slant of the mask 23 results in a slight protrusion of the sample 5 over the edge of the mask 21. The exact geometry of the alignment tool 27 depends on the desired height of the protrusion, i.e., how far the sample 5 is to protrude over the edge of the mask 21. The proposed concept also provides a system comprising the alignment component 20 and the alignment tool 27. For example, the alignment tool 27 may comprise at least one first alignment surface for aligning the alignment tool with the alignment component 20 (e.g., via alignment surface 23) and at least one second alignment surface for aligning the alignment tool 27 with the first and second alignment surfaces 4a, 4b, of the sample holder 1' holding the sample 5. For example, the first and second alignment surfaces may be the same or separate surfaces. A height difference between the first and second alignment surfaces may be used to control the protrusion of the sample over the edge of the mask.

Fig. 3c shows a schematic diagram of an example of the alignment tool 27 being pressed against alignment surfaces 23, 4a, 4b of the second alignment component 20 and the sample holder 1' while the fixture 6 is submerged in glue. The fixture 6 with the sample holder 1' is inserted into the alignment component with the gripper 26. The gripper 26 grips the fixture 6 at the recesses 6c, with the edges of the material adjacent to the recesses ensuring vertical alignment between the gripper 26 and the fixture 26. In Fig. 3c, the gripper comprises two prongs that lead into a common base at a grip of the gripper. The prongs comprise a first section that is adjacent to the common base, with a first smaller gap width between the two prongs. Then, in a second section that is adjacent to the first section, the width of the prongs increases, while the gap remains the same. In a third section, the gap widens to a second larger gap width, at least to a width of a portion of the fixture 6 at which the recesses 6c are located, to allow the fixture to be inserted between the prongs of the gripper 26, perpendicular to the fixture 6. The gap between the two prongs (at the first and second sections of the prongs) can be used to exert pressure onto the fixture 6.

The sample holder 1' is aligned with the help of the alignment/reference surfaces 23, 4a, 4b, and then placed against the mask. The alignment tool 27 is used as a mounting aid, using the alignment/reference surfaces 23 to the mask, with the alignment tool 27 being used as a stop for the alignment/reference surfaces 4a, 4b of the sample holder. As a result, the sample 5 (target) is at the height (i.e., cutting edge) of the mask 21, which limits the ion beam and removes everything above it.

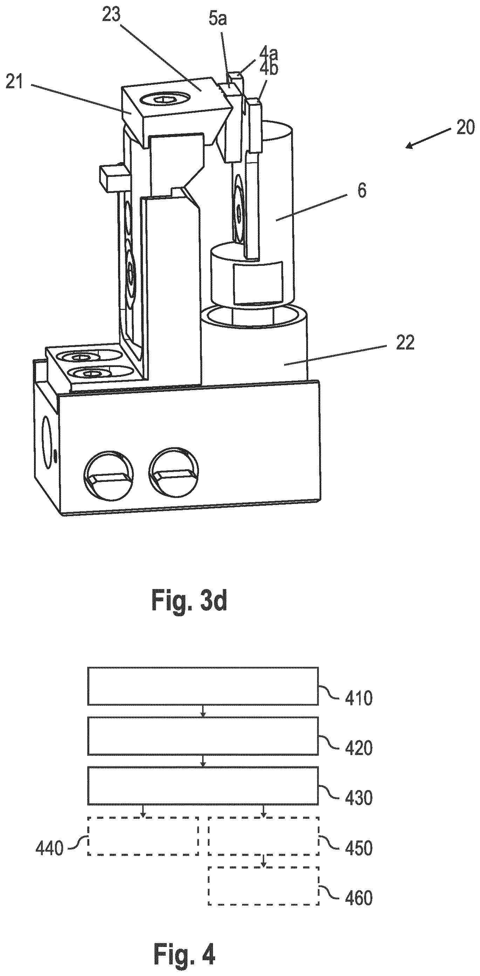

Fig. 3d shows a schematic diagram of an example of the sample 5 being aligned with the mask 21, after removal of the gripper 26. **The** stem of the fixture 6 protrudes into the vessel 22 with the adhesive. After alignment, the adhesive is hardened using UV radiation. Subsequently, the gripper 26 releases the fixture 6. **The** alignment component 20 is now ready for processing by the ion milling device.

Fig. 4 shows a flowchart of an example of a corresponding method for preparing the sample 5 for ion milling. **The** method comprises attaching 410 the sample 5 to a sample holder 1, 1' (e.g., as described in connection with Figs. 1a to 3d). **The** sample holder comprises a first and second structure 3a, 3b. For example, the sample may be attached using adhesive or a clamping mechanism.

The method comprises mechanically removing 420 material from the sample 5 and the first and second structure 3a, 3b, so that a resulting surface 5a of the sample 5 forms a discontinuous planar surface with the first and second surface 4a, 4b of the first and second structure 3a, 3b after removing the material from the sample and first and second structure. For example, a sample preparation device may be used to mechanically remove the material using one of a mechanical milling tool, a polishing disc, or a cutting/sawing disc.

The method comprises inserting 430 the sample holder 1, 1' with the sample into an alignment component 10, 20 for a sample stage for ion milling, such that the surfaces 4a, 4b of the first and second structure 3a, 3b press against at least one alignment surface 12a, 12b of the alignment component (as shown in connection with Figs. 2a to 2f) or against an alignment surface of an alignment tool 27 (as shown in connection with Figs. 3a to 3d). **The** surfaces of the first and second structure 3a, 3b are used as alignment surfaces 4a, 4b for aligning the sample holder 1, 1' and the sample 5 relative to a mask 11, 21 for partially shielding the sample during ion milling.

As part of the alignment process, the alignment surfaces 4a, 4b are pressed against another alignment surface, e.g., of the alignment component 10 (in case an alignment component 10 as shown in Figs. 2a to 2f is used) or of the alignment tool 27 (in case an alignment component 20 as shown in Figs. 3a to 3d is used). In the former case, mechanisms may be used to a) press the sample holder 1 against the alignment surfaces 12a, 12b of the alignment component 10, and to hold the sample holder 1 in place. For example, an alignment mechanism 13, 14 of the alignment component 10 may be used to press the surfaces 4a, 4b of the first and second structure against a first and second alignment surface 12a, 12b of the alignment component. Additionally, or alternatively, the method may comprise fastening 440 the sample holder to the alignment component 10 using a retaining mechanism 15, 16 of the alignment component 10.

In case of the alignment component 20 of Figs. 3a to 3d, glue/adhesive may be used to fix the sample holder in place. For example, the method may comprise placing 450 a fixture 6 mechanically coupled to the sample 5 into a vessel 22 of the alignment component comprising an adhesive. For example, a gripper 26 may be used to place the fixture with the sample holder 1' into the vessel 22 with the adhesive. In this case, the adhesive is used to maintain alignment between the sample 5 and the mask 21. To harden the adhesive, the method may further comprise emitting 460 ultra-violet light towards the adhesive.

As used herein the term "and/or" includes any and all combinations of one or more of the associated listed items and may be abbreviated as "/".

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

### List of reference Signs

- 1, 1':: Sample holder
- 2:: Body
- 2a:: Edge of the body
- 3a:: First structure
- 3b:: Second structure
- 4a:: First alignment surface
- 4b:: Second alignment surface
- 5:: Sample
- 5a:: Resulting surface of the sample
- 6:: Fixture mechanically coupled to the sample
- 7a:: Insert
- 7b:: Screw
- 8:: Recess
- 10:: Alignment component
- 11:: Mask
- 12a:: First alignment surface
- 12b:: Second alignment surface
- 13:: Alignment mechanism
- 14:: Adjustment screw
- 15:: Retaining mechanism
- 16:: Retaining mechanism
- 17:: Base
- 18:: Structure
- 20:: Alignment component
- 21:: Mask
- 22:: Vessel
- 23:: At least one alignment surface
- 24:: Base
- 25:: Holding structure
- 26:: Gripper
- 27:: Alignment tool
- 30a, 30b:: Ion source
- 410:: Attaching the sample to a sample holder
- 420:: Mechanically removing material
- 430:: Inserting the sample holder into an alignment component
- 440:: Fastening the sample holder to the alignment component
- 450:: Placing a component into a vessel
- 460:: Emitting ultra-violet light

## Claims

1. A sample holder (1, 1') for use in ion milling, wherein the sample holder comprises a body (2) for attaching the sample (5) and first and second alignment surfaces (4a, 4b) to be pressed against corresponding alignment surfaces of an alignment component or alignment tool.

2. The sample holder according to claim 1, wherein the first and second alignment surfaces (4a, 4b) are formed by surfaces of a first and second structure (3a, 3b).

3. The sample holder according to claim 2, wherein the body (2) and the first and second structures (3a, 3b) are arranged such that, when material is removed from a sample (5) attached to the body of the sample holder during preparation of the sample for ion milling, material is also removed from the first and second structures (3a, 3b), resulting in a discontinuous planar surface across the resulting surface (5a) of the sample and the resulting alignment surfaces (4a, 4b).

4. The sample holder according to one of the claims 2 or 3, wherein the body (2) and the first and second structures (3a, 3b) are arranged such that, when a sample (5) is attached to the sample holder, the sample protrudes over an edge (2a) of the body (2) of the sample holder in a pre-defined direction, with the first and second structures (3a, 3b) extending beyond the edge (2a) of the body (2) in the pre-defined direction
and/or wherein the body (2) of the sample holder is arranged laterally between the first and second structures (3a, 3b).

5. The sample holder according to one of the claims 2 to 4, wherein the first and second structures (3a, 3b) are block-like structures provided to be partially removed during preparation of the sample for ion milling, resulting in a discontinuous planar surface across the resulting surface (5a) of the sample (5) and the resulting alignment surfaces (4a, 4b).

6. The sample holder according to one of the claims 2 to 5, wherein the first and second structures (3a, 3b) are removably mounted to the body of the sample holder using screws.

7. The sample holder according to one of the claims 1 to 6, wherein the body (2) of the sample holder is provided for attaching the sample (5) to the sample holder via adhesive.

8. The sample holder according to one of the claims 1 to 7, wherein the sample holder is provided for holding the sample (5) during preparation of the sample for ion milling and during ion milling.

9. An alignment component (10) for a sample stage for use in ion milling, the alignment component comprising:
a mask (11) for partially shielding the sample during ion milling or a holder for fastening the mask to the alignment component; and
a first and second alignment surface (12a, 12b) for aligning a sample holder (1, 1') holding a sample with the mask,
wherein the first and second alignment surfaces have a defined spatial relationship relative to the mask.

10. The alignment component according to claim 9, wherein the alignment component comprises an alignment mechanism (13, 14) configured to mechanically press alignment surfaces of the sample holder against the first and second alignment surfaces of the alignment component,
and/or wherein the alignment component (10) further comprises a retaining mechanism (15, 16) for limiting a movement of the sample holder perpendicular to a direction of movement of the alignment mechanism.

11. An alignment component (20) for a sample stage for use in ion milling, wherein the alignment component comprises:
a mask (21) for partially shielding a sample during ion milling or a holder for fastening the mask to the alignment component,
a vessel (22) for an adhesive, wherein the vessel is provided to receive a fixture (6) mechanically coupled to the sample, with the adhesive being used to maintain alignment between the sample and the mask, and
at least one alignment surface (23) for aligning at least the mask or holder with a first and second alignment surface of a sample holder holding the sample via an alignment tool (27), wherein the at least one alignment surface has a defined spatial relationship with the mask.

12. A system comprising the alignment component (20) according to claim 11 and the alignment tool, the alignment tool comprising at least one first alignment surface for aligning the alignment tool with the alignment component and at least one second alignment surface for aligning the alignment tool with at least a first and second alignment surface of a sample holder holding the sample, wherein the alignment tool is suitable for aligning the sample holder and the mask via the respective alignment surfaces.

13. A method for preparing a sample for ion milling, the method comprising:
attaching (410) the sample (5) to a sample holder (1, 1'), the sample holder comprising a first and second structure (3a, 3b);
mechanically removing (420) material from the sample (5) and the first and second structure (3a, 3b), so that a resulting surface (5a) of the sample forms a discontinuous planar surface with a first and second surface (4a, 4b) of the first and second structure (3a, 3b) after the material is removed from the sample and first and second structure;
inserting (430) the sample holder (1, 1') with the sample into an alignment component (10, 20) for a sample stage for ion milling, such that the surfaces (4a, 4b) of the first and second structure press against at least one alignment surface (12a, 12b) of the alignment component or of an alignment tool,
with the surfaces of the first and second structure being used as alignment surfaces for aligning the sample holder (1, 1') and the sample (5) relative to a mask (11, 21) for partially shielding the sample during ion milling.

14. **The** method according to claim 13, wherein an alignment mechanism (13, 14) of the alignment component (10) is used to press the surfaces (4a, 4b) of the first and second structure against a first and second alignment surface (12a, 12b) of the alignment component.

15. **The** method according to claim 13, wherein the method comprises placing (450) a fixture (6) mechanically coupled to the sample (5) into a vessel (22) of the alignment component, with the vessel comprising an adhesive, with the adhesive being used to maintain alignment between the sample and the mask (21).
